# EUROPÄISCHE PATENTSCHRIFT

(11) **EP 1 656 470 B1**
(45) Veröffentlichungstag und Bekanntmachung des Hinweises auf die Patenterteilung: **05.10.2011**
(21) Anmeldenummer: 04762397.0
(22) Anmeldetag: 13.07.2004
(51) Int. Cl.: C25B 1/00

(54) **PHOTOVOLTAIKSYSTEM FÜR DIE DIREKTE WASSERSTOFFERZEUGUNG UND SAMMLUNG**
PHOTOVOLTAIC SYSTEM FOR DIRECT HYDROGEN PRODUCTION AND COLLECTION
SYSTEME PHOTOVOLTAIQUE DESTINE A LA PRODUCTION ET A LA COLLECTE DIRECTES D'HYDROGENE

(30) Priorität: 13.07.2003 DE 10332570
(43) Veröffentlichungstag der Anmeldung: 17.05.2006
(73) Patentinhaber: Helmholtz-Zentrum Berlin für Materialien und Energie GmbH, 14109 Berlin (DE)
(72) Erfinder: TRIBUTSCH, Helmut, 14109 Berlin (DE)
(74) Vertreter: Rudolph, Margit
(86) Internationale Anmeldenummer: PCT/DE2004/001542
(87) Internationale Veröffentlichungsnummer: WO 2005/007932

(56) Entgegenhaltungen:
- WO-A-01/02624
- FR-A- 2 410 506
- US-A- 4 466 869
- US-A- 4 650 554
- US-A- 5 772 792
- US-A- 6 019 954
- PATENT ABSTRACTS OF JAPAN Bd. 2003, Nr. 09, 3. September 2003 (2003-09-03) & JP 2003 146602 A (NIPPON SHEET GLASS CO LTD), 21. Mai 2003 (2003-05-21)

## Beschreibung

Die Erfindung bezieht sich auf ein Photovoltaiksystem für die direkte Wasserstofferzeugung und -sammlung durch einen Elektrolysestrom in einem Behälter mit einer von Wasser umgebenen und zumindest von einer Seite mit gesammeltem Sonnenlicht bestrahlten photoelektrochemisch aktiven Photovoltaikstruktur ohne laterale stromsammelnde Elemente, die eine eine integrierte Protonenschleuse aufweisende selbsttragende Membran umfasst, die das umgebende Wasser gegenüber dem Behälter in zwei getrennte Wasserkammern zur Wasserstoff- und zur Sauerstofferzeugung unterteilt, wobei auf der der Wasserkammer zur Sauerstofferzeugung zugewandten Seite der Photovoltaikstruktur eine Titandioxidschicht vorgesehen.

Bei der Elektrolyse wird Wasser durch einen fließenden elektrischen Strom gespalten. Diese Wasserdissoziation erfolgt in erster Linie zur Erzeugung von Wasserstoff als umweltfreundlichem Brennstoff. Neben der klassischen Elektrolyse durch Stromfluss zwischen zwei Elektroden werden auch eine Reformierung von Kohlenwasserstoffen oder eine Thermolyse von Wasser zur Wasserstoffherstellung eingesetzt. Neuere, primärenergie- und umweltschonende Verfahren sind beispielsweise die Kultivierung genetisch veränderter Algen oder die für die Erfindung wichtige direkte Wasserelektrolyse, bei der Solarenergie direkt ohne Zwischenerzeugung und -speicherung von Solarstrom eingesetzt wird. Hier dient eine photosynthetische Membran in der Natur als Vorbild, bei der zwar auch elektrische Phänomene zur Brennstofferzeugung genutzt werden, es wird jedoch kein Strom, sondern Primärbrennstoff gesammelt. Bei diesem Kaskadensystem werden zwei verschiedene Lichtreaktionen, zuerst eine photovoltaische, dann eine photokatalytische Reaktion, hintereinander geschaltet. Zur technischen Umsetzung dieser direkten Wasserelektrolyse werden in der Regel mehrere Solarzellen in Serie geschaltet, um die notwendige Zersetzungsspannung zu erreichen. Die Zelloberfläche ist mit einem metallenen Katalysator überzogen, an dem sich das Wasser spaltet. Als photoelektrochemische (PEC) Solarzellen werden z.B. Stapel von verschiedenen Zelltypen (Z.B. Tandem-Solarzelle) verwendet, die unterschiedliche Wellenlängen absorbieren und das eingestrahlte Sonnenlicht daher besser ausnutzen als eine einzelne Zelle. Es sind verschiedene Halbleiter in der Erforschung, unter anderem amorphes Silizium, das zwar relativ kostengünstig ist, aber nur maximal 13% Wirkungsgrad hat und nur begrenzt stabil ist. Andere Typen sind Gallium-Indium-Diphosphat oder Gallium-Arsenid, die zwar höhere Wirkungsgrade (über 25%), aber auch deutlich höhere Kosten zeigen. Diese Technik könnte in Zukunft die billige Herstellung von Wasserstoff ermöglichen, doch noch ist das Problem der Korrosion zu lösen. Denn die Solarzellen, insbesondere auch die elektrischen Kontakte, altern unter dem Einfluss des Elektrolyts (einer Säure oder Base) schnell. Eine kostenintensive Versiegelung des Solarzellenschichtaufbaus stellt in der Regel auch keine praktikable Lösung dar.

In der Veröffentlichung I von O. Khasalev und J.A: Turner "A monolithic Photovoltaic-Photoelectrochemical Device for Hydrogen Production via Water Splitting" (SCIENCE, Vol. 280, April 1998, pp. 425-427) wird in dem dort diskutierten photovoltaischen photoelektrochemischen Photovoltaiksystem für die Wasserstoffproduktion durch Wasserspaltung aufgezeigt, dass nach dem Vorbild einer solaren Tandemzelle eine p-Gallium-Indium-diphosphid-Schicht als elektrochemisch aktive Schicht, die einseitig von Sonnenlicht bestrahlt wird, über eine Pufferschicht in Serie geschaltet mit einer p-n-Gallium-arsenid-Solarzelle ist. Eine transparente Metallschicht auf der Unterseite der Solarzelle dient als Ohmscher Kontakt. Stromsammelnde Elemente auf der Oberseite der Solarzelle sind durch die direkte Nutzung des Photostroms nicht erforderlich. Die gesamte Tandem-Photovoltaikstruktur ist von Wasser umgeben. Der Metallschicht gegenüber ist im Wasser eine Platinfläche als Metallanode angeordnet, sodass sich dazwischen das stromdurchflossene Elektrolysegebiet ausbildet. Die von diesem Photovoltaiksystem erzeugte Photospannung reicht aus, um das Wasser im Elektrolysegebiet zu dissoziieren. Die verwendeten Oberflächen sind aber entweder nicht ausreichend korrosionsfest gegenüber dem Elektrolyten und giftig (Solarzelle) oder besonders teuer (Metallanode).

Aus der Veröffentlichung II von S. Licht et al.: "Efficient Solar Water Splitting, Exemplified by RuO2-Catalyzed ALGaAs/Si Photoelectrolysis" (J. Phys. Chem. B 2000, 104, pp. 8920-8924) ist ein anderes Photovoltaiksystem bekannt, bei dem die Photovoltaikstruktur außerhalb des Wassers angeordnet ist. Das Elektrolysegebiet befindet sich zwischen einer Platinelektrode und einer Rutheniumdioxid-Elektrode, die beide aus der Photovoltaikstruktur heraus in das Wasser reichen. Der Solarzellenschichtaufbau der Photovoltaikstruktur, der ebenfalls keine stromsammelnden Elemente aufweist, ist parallel zur Wasseroberfläche ausgerichtet, die Sonnenlichtbestrahlung erfolgt von der Oberseite des Solarzellenschichtaufbaus in einem relativ kleinen Einstrahlbereich. Bei diesem Photovoltaiksystem sind zwar die korrosionsanfälligen Halbleiterschichten der Photovoltaikstruktur außerhalb des Wassers angeordnet, bleiben aber wegen der Kapillarkräfte und der Luftfeuchtigkeit trotzdem stark korrosionsgefährdet. Ein wirksamer Schutz ist hier auch nicht bekannt. Im Wasser werden außerdem teure oder aufwändig herzustellende Elektroden verwendet. Über die Trennung und Sammlung der erzeugten Dissoziationsgase werden in beiden Veröffentlichungen keine näheren Informationen gegeben.

Die vorliegende Erfindung geht von der FR-A-2 410 506 als nächstliegendem Stand der Technik aus. Es wird ein Photovoltaiksystem für die direkte Wasserstofferzeugung und -sammlung durch einen Elektrolysestrom in einem Behälter offenbart, das eine von Wasser umgebene und von beiden Seiten mit gesammeltem Sonnenlicht bestrahlte, photoelektrochemisch aktive Photovoltaikstruktur ohne laterale stromsammelnde Elemente aufweist. Weiterhin umfasst das Photovoltaiksystem eine selbsttragende Membran, in die eine Protonenschleuse integriert ist und die das umgebende Wasser gegenüber dem Behälter in zwei getrennte Wasserkammern unterteilt. In der anodischen Wasserkammer wird Sauerstoff, in der kathodischen Wasserkammer wird Wasserstoff freigesetzt. Bei dem bekannten Photovoltaiksystem hat die Membran selbst keine photovoltaischen Eigenschaften und dient der Aufnahme der Protonenschleuse und zumindest eines Einzelblocks, der einen photovoltaischen Übergang zur Erzeugung des lichtinduzierten Elektrolysestroms umfasst. Dabei ist der Einzelblock über einen Dichtungsring in einen entsprechenden Ausschnitt in der Membran eingepasst. Zum Schutz gegenüber dem Wasser und zur Erhöhung des Wasserspaltungsumsatzes ist der photovoltaische Übergang beidseitig mit einer metallischen Schicht belegt. Auf der der Wasserkammer zur Sauerstofferzeugung zugewandten Seite der Photovoltaikstruktur ist eine n-leitende Titandioxidschicht als Anode auf der metallischen Schicht vorgesehen. Weiterhin befindet sich in der Wasserkammer zur Wasserstofferzeugung eine Platin- oder p-leitende Halbleiterschicht als Kathode. Eine Umsatzerhöhung der Brennstofferzeugung wird bei dem bekannten Photovoltaiksystem ausschließlich konstruktiv durch das Vorsehen der beiden metallischen Schichten beiderseits des photovoltaischen Übergangs hervorgerufen.

Aus der WO 01/02624 A1 ist es für ein Photovoltaiksystem mit einem Feststoffelektrolyten weiterhin bekannt, dass TiO₂ in Verbindung mit einem WO₃-Film zur Reduktion von Wasser zu Wasserstoff beiträgt. Weiterhin sind aus der US-A-6 019 954 und aus der US-A-4 650 554 planare Anordnungen zur Elektrolyse des Wassers bekannt, bei denen photovoltaische Energie in externer oder integrierter Weise genutzt wird."

Die Aufgabe für die vorliegende Erfindung ist daher darin zu sehen, ein Photovoltaiksystem der eingangs beschriebenen Art so auszubilden, dass umweltfreundliche und kostengünstige Materialien bei einer optimalen Korrosionsstabilität der eingesetzten Photovoltaikstruktur verwendet werden können. Insgesamt soll das erfindungsgemäße Photovoltaiksystem möglichst einfach und kompakt sein und kein aufwändiges Elektrolyseelektrodensystem aufweisen. Weiterhin soll es eine einfache Trennung der gewonnenen Dissoziationsgase ermöglichen. Als Lösung für diese Aufgabe ist bei einem Photovoltaiksystem der gattungsgemäßen Art für die direkte Wasserstofferzeugung und - sammlung durch einen Elektrolysestrom in einem Behälter mit einer von Wasser umgebenen und zumindest von einer Seite mit gesammeltem Sonnenlicht bestrahlten, photoelektrochemisch aktiven Photovoltaikstruktur ohne stromsammelnde Elemente deshalb erfindungsgemäß vorgesehen, dass die Membran als vom Elektrolysestrom durchflossene selbsttragende Photovoltaikmembran ausgebildet ist und auf beiden Seiten mit einer elektrisch leitenden und lichtdurchlässigen Titandioxidschicht belegt ist, wobei die Titandioxidschicht auf der einen Seite der Photovoltaikmembran durch Dotierung mit Stickstoff, Schwefel oder Kohlenstoff oder Kombinationen davon sauerstoffkatalysierende Eigenschaften hat und die Titanoxidschicht auf der der Wasserkammer zur Sauerstofferzeugung zugewandten Seite des Photovoltaikstruktur bildet und die Titandioxidschicht auf der anderen Seite der Photovoltaikmembran durch Einlagerung von Nickelmolybdänpartikeln oder ähnlich wirkenden Wasserstoffkatalysatoren oder Kombinationen davon wasserstoffkatalysierende Eigenschaften hat.

Das erfindungsgemäße Photovoltaiksystem umfasst eine optimierte Photovoltaikstruktur in Form einer Photovoltaikmembran mit einer durchgehend elektronisch wirksamen, funktionellen Struktur, deren brennstofferzeugende Oberflächen aus materialtechnisch modifiziertem Titandioxid bestehen, das auch in einem wässrigen Elektrolyten thermodynamisch stabil und damit absolut korrosionsstabil ist. Dabei ist das elektronisch aktive Titandioxid ein umweltfreundliches und kostengünstiges Produkt, sodass sich gegenüber der Verwendung von teuren Edelmetallen eine bedeutsame Kostenersparnis ergibt. Titandioxid ist untoxisch, sodass der Einsatz problemlos erfolgen kann. Die als photoaktive bzw. Fensterschichten wirkenden Titandioxidschichten/die auf die Photovoltaikstruktur beispielsweise aufgesputtert werden können, wirken aber nicht versiegelnd, sondern sind selbst photoaktiv. Auf der Anodenseite (Sauerstoffentwicklung) können sie bereits einen großen Beitrag zur erzeugbaren Photospannung liefern. Weiterhin ist das erfindungsgemäße Photovoltaiksystem mit seinen stabilen Oberflächen äußerst kompakt in seinen Abmessungen, da die Photovoltaikmembran selbst den Leiter und den Katalysator zugleich bildet und den Elektrolysekreislauf direkt über die angrenzenden Wasserkammern und die Protonenschleuse schließt. Ein separates Elektrolytsystem mit zueinander beabstandeten Elektroden zur Bildung eines Elektrolysebereichs entfällt, eine Elektrolyse in einem zusätzlichen Elektrolyten findet nicht statt. Der erzeugte Elektrolysestrom durchwandert die Photovoltaikmembran auf der gesamten Fläche von der Kathodenseite (Wasserstoffentwicklung) zur Anodenseite. Die in die Photovoltaikmembran integrierte Protonenschleuse sorgt für einen Transport der Protonen von der Anodenseite, wo Protonen bei der Sauerstoffproduktion freigesetzt werden, auf die Kathodenseite, wo die Protonen zur Wasserstoffproduktion verbraucht werden. Einen hohen Wirkungsgrad bei der Wasserspaltung erreicht das erfindungsgemäße Photovoltaiksystem außerdem auch dadurch, dass die freitragende Photovoltaikmembran von beiden Seiten gleichzeitig mit gesammeltem Sonnenlicht bestrahlt wird. Dazu wird eine entsprechende Lichtführung eingesetzt, die in verschiedenen Varianten ausgeführt sein kann (siehe auch weiter unten). Einfachstenfalls handelt es sich hierbei um entsprechend gestaltete und angeordnete Kollektoren und Reflektoren. Das Sonnenlicht erreicht somit sowohl die sauerstoffkatalysierende Titandioxidschicht wie auch direkt die integrierte Photovoltaikstruktur, die den Elektrolysestrom antreibt, und die darüber liegende, wasserstoffkatalysierende Titandioxidschicht.

Weiterhin umfasst die Photovoltaikmembran des erfindungsgemäßen Photovoltaiksystems nur eine Photovoltaikstruktur in Form einer Solarzelle mit einem stark vereinfachten Aufbau, wodurch der Einsatz von giftigen Stoffen vermieden oder zumindest auf ein Minimum reduziert wird. Aufwändig zu strukturierende und korrosionsanfällige stromsammelnde Elemente, wie sie bei Solarzellen üblicherweise verwendet werden, entfallen ebenfalls. Durch diesen Wegfall der lateralen Stromsammlung ist keine hohe Leitfähigkeit der Deckschichten mehr erforderlich, sodass auch das relativ schlecht elektrisch leitende Titandioxid problemlos eingesetzt werden kann. Bei Solarzellen wird für die stromsammelnden Elemente in der Regel das gut leitende, aber giftige und korrosionsinstabile Zinkoxid verwendet. Die zur direkten Brennstofferzeugung erforderliche Photospannung zwischen den beiden modifizierten Titandioxidschichten wird bei der Erfindung ohne Weiteres erreicht. Weiterhin entstehen durch die Systemoptimierung der Photovoltaikmembran bei dem erfindungsgemäßen Photovoltaiksystem als konstruktive Trennwand in einem Behälter in einfacher Weise zwei getrennte Wasserkammern, in denen durch die jeweils unterschiedlich materialtechnisch modifizierten Titandioxidschichten jeweils ein anderes Dissoziationsgas erzeugt wird. Eine Ableitung der separiert erzeugten Dissoziationsgase ist daher unproblematisch und erfordert keine weiteren Trennmaßnahmen.

Die Verwendung von Titandioxidschichten im photovoltaischen Bereich, insbesondere aufgrund seiner photokatalysatorischen Eigenschaften als Photoanode bei der Trennung von Wasser, ist aus dem Stand der Technik allgemein bekannt und Gegenstand intensiver Forschungen. Dabei ist die Modifikationsfähigkeit von Titandioxid (TiO₂) von besonderer Bedeutung. Nach Ausführungsformen der Erfindung ist es daher vorteilhaft, wenn die materialtechnisch modifizierte Titandioxidschicht mit den sauerstoffkatalysierenden Eigenschaften mit Stickstoff, Schwefel oder Kohlenstoff oder Kombinationen davon dotiert ist und/oder wenn in die Titandioxidschicht mit den wasserstoffkatalysierenden Eigenschaften Nickelmolybdänpartikel oder ähnlich wirkende Wasserstoffkatalysatoren oder Kombinationen davon eingelagert sind. Durch die Dotierung von Titandioxid mit Stickstoff, Schwefel oder Kohlenstoff wird dessen spektrale Lichtempfindlichkeit erhöht, die so in einem Bereich vom nahen UV-Licht bis in das kurzwelligere sichtbare Gebiet ausgedehnt werden kann. Durch beide Dotierungsmaßnahmen können also die katalytischen Fähigkeiten der Titandioxidschichten zur Erzeugung von Wasserstoff bzw. Sauerstoff jeweils bedeutsam gesteigert werden, sodass durch eine ausreichende Anzahl von Protonen und Elektronen Wasserstoff in großen Mengen erzeugt werden kann. Weiterhin ist bekannt, dass undotiertes Titandioxid kein sichtbares Licht absorbieren kann, weshalb es gerne als weißes, lichtstreuendes Farbpigment verwendet wird. Obwohl bereits nichtsichtbare Anteile aus dem Sonnenlicht zur Erzeugung von Solarstrom in undotiertem Titandioxid genutzt werden können, ist es zur weiteren Steigerung der Stromausbeute noch sinnvoll, wenn gemäß einer nächsten Erfindungsausgestaltung in die Titandioxidschichten photoaktive Farbstoffpigmente eingelagert sind. Durch diese genannten Maßnahmen, in die auch noch weitere, unter Umständen erst bei der weiteren Forschung ermittelte Modifizierungen einzubeziehen sind, erreicht das bei der Erfindung eingesetzte Titandioxid für den beabsichtigten Zweck der vornehmlichen Wasserstofferzeugung unter gleichzeitigem zuverlässigem, Korrosionsschutz der Photovoltaikstruktur ausgezeichnete Eigenschaften.

Aus dem Stand der Technik bekannte Titandioxidschichten werden jedoch bislang nur als Beschichtungen und nicht für eine selbsttragende Photovoltaikmembran wie bei der Erfindung eingesetzt. Durch die selbsttragende Eigenschaft können aber bei dem Photovoltaiksystem nach der Erfindung stabilisierende und einspannende Maßnahmen entfallen und ein einfacher und gut zugänglicher Aufbau realisiert werden. Dabei ist es besonders günstig, wenn gemäß einer nächsten Erfindungsausgestaltung vorteilhaft vorgesehen ist, dass die Photovoltaikmembran flexibel ausgebildet ist. Dadurch können nahezu beliebige geometrische Ausgestaltungen der Wasserkammern zur getrennten Dissoziationsgaserzeugung realisiert werden, was weiter unten in der Beschreibung noch eingehend erläutert wird. Zur inneren Stabilisierung der flexiblen Photovoltaikmembran kann jedoch gemäß einer nächsten Erfindungsausgestaltung vorgesehen sein, dass die Photovoltaikmembran eine zentrale, flexible Trägerfolie, insbesondere aus Titan, aufweist. Diese ist lichtundurchlässig und trennt die beiden Katalysegebiete. Für die Verwendung von Titan gelten , die bereits weiter oben angeführten bedeutsamen Vorteile. Vorteilhaft ist dabei auch, dass die Anzahl der einzusetzenden Materialien bei der Herstellung der Photovoltaikmembran für die Erfindung minimiert werden kann. Bei deren Flexibilisierung kann auch die Wahl der als Photovoltaikstruktur in die Membran einzubeziehenden, stark vereinfachten Solarzelle entsprechend ausfallen. Gemäß einer nächsten Erfindungsfortführung kann die integrierte Photovoltaikstruktur eine Dünnschichtsolarzelle, insbesondere unter Nutzung einer vereinfachten Kupfer-Indium-Selenid/Sulfid-Tandem-Solarzelle (CIS), oder eine amorphe oder kristalline Silizium-Solarzelle umfassen. Derartige Dünnschichtsolarzellen weisen eine gute Flexibilität auf. Dabei kann eine herkömmliche und somit kommerziell einfach und preiswert zu beziehende Solarzelle vorteilhaft eingesetzt werden, wenn gemäß einer nächsten Erfindungsfortführung in der Tandem-Dünnschichtsolarzelle oder in der Silizium-Solarzelle die üblichen Zink-Oxid-Fensterschichten durch die Titandioxidschichten ersetzt und die stromsammelnden Elemente entfernt sind.

Die Flexibilität der Photovoltaikmembran bei dem Photovoltaiksystem nach der Erfindung ist von besonderer Bedeutung da durch diese Eigenschaft eine spezielle Systemoptimierung mit einer besonders günstigen Licht- und brennstoffsammelnden Struktur realisiert werden kann. Gemäß einer bevorzugten Ausgestaltung der Erfindung kann vorteilhaft vorgesehen sein, dass die flexible Photovoltaikmembran als sich axial erstreckende Trennwand in einem flexiblen Schlauch beliebiger Länge als Behälter angeordnet ist und der Schlauch einen sich axial oberhalb der Photovoltaikmembran erstreckenden, flexiblen lichtdurchlässigen Einsatz als Lichtführung aufweist, wobei die Photovoltaikmembran unten von der Schlauchwandung und oben von dem lichtdurchlässigen Einsatz unter Bildung der beiden getrennten Wasserkammern abgeschlossen wird und wobei der Schlauch kontinuierlich in beiden Wasserkammern von Wasser in derselben Richtung durchflossen wird und die im Photovoltaiksystem entstehenden Dissoziationsgase zu Gastauschern mitführt. Durch diese Maßnahme kann ein weiterer, bedeutsamer Fortschritt gegenüber den bisherigen, recht theoretischen Ansätzen in der Literatur (vergleiche Veröffentlichungen 1 und 11) mit ihren sehr teuren und für eine Massenproduktion unpraktikabeln Materialien erreicht werden. Eine derartige licht- und brennstoffsammelnde Schlauchstruktur stellt dagegen eine sehr praktikable gleichzeitige Definition und Festlegung der Geometrie dar, in der die bei der direkten Elektrolyse eingesetzten Materialien in optimaler Weise für die praktische solare Energieumwandlung eingesetzt werden können. Die brennstofferzeugende Photovoltaikmembran ist dazu in einen flexiblen Schlauch, der im Durchmesser - genau wie in der Länge - nahezu beliebig festlegbar ist, eingebettet und bildet hier gleichsam über die gesamte Schlauchlänge eine Scheidewand zwischen den beiden Wasserkammern, die noch von dem Schlauch und dem lichtdurchlässigen Einsatz begrenzt werden. Das Sonnenlicht dringt durch den flexiblen, lichtdurchlässigen Einsatz, der nach einer Ausführungsform bevorzugt als einfache und preisgünstige Kunststofflinse mit einem kreisabschnittsförmigen Querschnitt ausgebildet sein kann, in das Schlauchinnere ein, fällt von beiden Seiten auf die Photovoltaikmembran und aktiviert großflächig den jeweiligen Dissoziationsprozess in dem durch den Schlauch fließenden Wasser. Dieses transportiert dann die getrennt entstehenden Gase gleichzeitig zu angeschlossenen Gastauschem, die mit Zwischenspeichern verbunden sein können. Somit ist bei der Erfindung ein optimaler Erzeugungs-, Transport- und Lagerungsprozess in sicherer und einfacher Form gewährleistet. Die Dimension des mit der brennstofferzeugenden integrierten Photovoltaikmembran versehenen Brennstoffschlauches kann groß oder klein sein. Im Vergleich zu herkömmlichen Technologien zur solaren Strom- und Brennstoffgewinnung ist der Material-und Systemaufwand bei dieser Ausführungsform des Photovoltaiksystems nach der Erfindung jedoch deutlich reduziert. Außerdem ist die Herstellungstechnologie völlig modifiziert und im Wesentlichen an die Technologie der Kabelherstellung angelehnt. Dadurch können zusätzliche Potenziale für die Kostenreduzierung erschlossen werden. Da keine stromsammelnden Elemente aus Metall, wie bei einer normalen Solarzelle, vorhanden sind, kann es auch nicht zu Korrosions- oder Kurzschlussprozessen kommen. Wenn trotzdem einzelne mikroskopische Bereiche der integrierten Photovoltaikmembran korrodieren, bleibt diese ohne Auswirkungen auf die Funktion des Photovoltaiksystems und die Brennstoffproduktion wird aufrecht erhalten. Da die vorgeschlagene Technologie mit einem Brennstoffschlauch im Freien realisiert werden kann, kann aus eventuell vorhandenen Lecks austretender Wasserstoff unter Gewährleistung des freien Abzugs direkt in die Atmosphäre und den Weltraum austreten, ohne dass ein unkalkulierbares Gefahrenpotenzial auftritt. Ein weiterer Vorteil des beschriebenen Schlauchtechnologie besteht darin, dass bis zur Belastungsgrenze der eingesetzten Materialien eine beliebig hohe Lichtkonzentration auf die Schlauchstruktur gelenkt werden kann, da keine limitierende Stromsammlung erfolgt. Dabei kann vorteilhaft gemäß einer Erfindungsausgestaltung das bestrahlende Sonnenlicht über einen Konzentrator als weitere Lichtführung auf die Photovoltaikmembran gelenkt werden. Außerdem kühlt das im Schlauch strömende Wasser die Photovoltaikmembran ab bzw. begünstigen hohe Wassertemperaturen die Wasserspaltung energetisch. Die eingesetzten Materialien sind, mit Ausnahme gegebenenfalls vorhandener geringer Mengen von Indium bei Verwendung eines CIS-Solarzelle, unbedenklich und reichlich vorhanden. Außerdem können ohne Weiteres auch zukünftige, alternative Photovoltaikstrukturen, insbesondere Tandem-Photovoltaikstrukturen, in die titandioxidgeschützte Photovoltaikmembran des Photovoltaiksystem nach der Erfindung integriert werden.

Bei Verwendung eines Brennstoffschlauches kann die Protonenrückführung durch die Protonenschleuse realisiert werden, indem gemäß einer nächsten Erfindungsfortführung in der Photovoltaikmembran in regelmäßigen Abständen Membranelemente als Protonenschleusen angeordnet sind, die einen Protonenaustausch zwischen den beiden, in dem Schlauch ausgebildeten und sehr langgestreckten Wasserkammern sicher gewährleisten. Zur Verbesserung der beidseitigen Lichteinstrahlung in die sehr langgestreckte Photovoltaikmembran kann weiterhin nach einer nächsten Erfindungsausgestaltung noch vorgesehen sein, dass der Schlauch auf seiner Innenseite im Bereich der beiden getrennten Wasserkammern eine lichtreflektierende Oberfläche als weitere Lichtführung aufweist. Auf die Schlauchinnenseite durch den lichtdurchlässigen Einsatz auftreffende Sonnenstrahlung wird so in Richtung auf die Photovoltaikmembran reflektiert und damit auch genutzt. Eine gute, aber preisgünstige und einfach herzustellende Reflexionsschicht mit gleichzeitigem Schutz der Schlauchinnenseite vor Kalkablagerungen ist gegeben, wenn gemäß einer nächsten Erfindungsfortführung die lichtreflektierende Oberfläche als Aluminiumschicht, die mit einer wasserkorrosionsbeständigen Siliziumdioxidschicht bedeckt ist, ausgebildet ist. Die Siliziumdioxidschicht bildet darüber hinaus auch den optimalen Untergrund für eine winstonartige Kollektorstruktur, die gemäß einer weiteren Fortbildung des Photovoltaiksystems nach der Erfindung der Schlauch auf seiner Innenseite im Bereich der getrennten Wasserkammern als weitere Lichtführung aufweisen kann. Diese spezielle Kollektorstruktur verläuft mit solchen Krümmungen, dass das gesamte einfallende Sonnenlicht sicher auf die Photovoltaikmembran reflektiert wird und nicht teilweise ungenutzt durch den lichtdurchlässigen Einsatz den Schlauch wieder verlässt. Durch diese einfache Maßnahme kann der Wirkungsgrad des Photovoltaiksystems nach der Erfindung bei der Umsetzung von solarer Energie in die Wasserelektrolyse nochmals gesteigert werden.

Die flexible Ausbildung der Photovoltaikmembran ist bei dem beschriebenen Systemkonzept besonders vorteilhaft. Dadurch kann der Schlauch nicht nur gerade, sondern auch beliebig gekrümmt verlegt werden. Dabei versteht es sich von selbst, dass bei der Verlegung immer der lichtdurchlässige Einsatz im Schlauch, in Richtung auf das Sonnenlicht zeigt. Eine besonders günstige und platzsparende Anordnung ergibt sich beim Einsatz einer flexiblen Photovoltaikmembran gemäß einer nächsten Erfindungsausgestaltung, bei der vorteilhaft vorgesehen ist, dass der Schlauch in einer beliebig geformten Paneele, insbesondere in Form einer flächigen Schlauchspirale, ausgelegt ist. Derartige Paneele sind einfach zu handhaben, lassen sich bequem transportieren und modulartig montieren. Eine direkte Schlauchverlegung ist aber auch ohne Weiteres möglich. Eine besonders günstige Platznutzung mit einem akzeptablen Schlauchkrümmungsradius ergibt sich dabei bei einer spiralförmigen Auslegung. Dabei kann die Schlauch aus der Mitte radial oder nach einer größeren Innenschleife entgegengesetzt spiralförmig zurückgeführt werden. Die Auslegung des Schlauchs in einer Ebene ist zwar bezüglich maximaler Sonneneinstrahlung die günstigste, gegen eine räumliche Überkreuzung zur Erreichung optimaler Auslegungs- und Rückführungsstrukturen ist jedoch nichts einzuwenden.

Die licht- und brennstoffsammelnde Schlauchstruktur ist besonders einfach und kostengünstig in ihrem Aufbau und völlig flexibel in Größe und Form der Auslegung in ihrer Anpassung an jeden speziellen Applikationsfall. Das durch den Schlauch fließende Wasser transportiert die Dissoziationsgase direkt zu den Gastauschern. Beim Durchfließen des Schlauches wird das Wasser durch die Sonneneinstrahlung auch stark erwärmt. Nach einer nächsten Erfindungsfortführung ist es deshalb sinnvoll, wenn das den Schlauch durchfließende Wasser über einen integrierten Wärmetauscher geleitet wird. Auf diese Weise kann noch solarenergetisch erzeugte Wärme rückgewonnen und weiterverwendet werden. Grundsätzlich eignet sich das Photovoltaiksystem nach der Erfindung zur Erzeugung von Wasserstoff und Sauerstoff, wobei diese Dissoziationsgase vorteilhaft einem integrierten Brennstoffzellensystem zugeführt werden können. Statt Wasserstoff zu produzieren, kann jedoch auch auf der reduktiven Kathodenseite der integrierten Photovoltaikmembran mittels einer entsprechend anders modifizierten titanbasierten Kathodenoberfläche auch Sauerstoff zu Wasserstoffperoxid reduziert werden. In diesem Fall kann mit dem hergestellten Wasserstoffperoxid beispielsweise verunreinigtes, mit chemischen Substanzen versetztes Wasser behandelt und neutralisiert werden. Der erzeugte Wasserstoff kann auch zu einer weiteren Reaktion gebracht werden, sodass der Wasserstoff chemisch gebunden in Form eines anderen Wasserstoffträgers in der gleichen Systemgeometrie des Photovoltaiksystems nach der Erfindung gewonnen werden kann.

Ausbildungsformen des Photovoltaiksystems nach der Erfindung mit einer integrierten Photovoltaikmembran werden nachfolgend anhand der schematischen Figuren näher erläutert. Dabei zeigt :
- **Figur 1**: das Prinzipschema einer integrierten Photovoltaikmembran,
- **Figur 2**: das Energieschema einer integrierten Photovoltaikmembran,
- **Figur 3**: einen Querschnitt durch einen Brennstoffschlauch,
- **Figur 4**: einen aufgewickelten Brennstoffschlauch in der Ansicht und
- **Figur 5**: ein gekoppeltes Photovoltaiksystem.

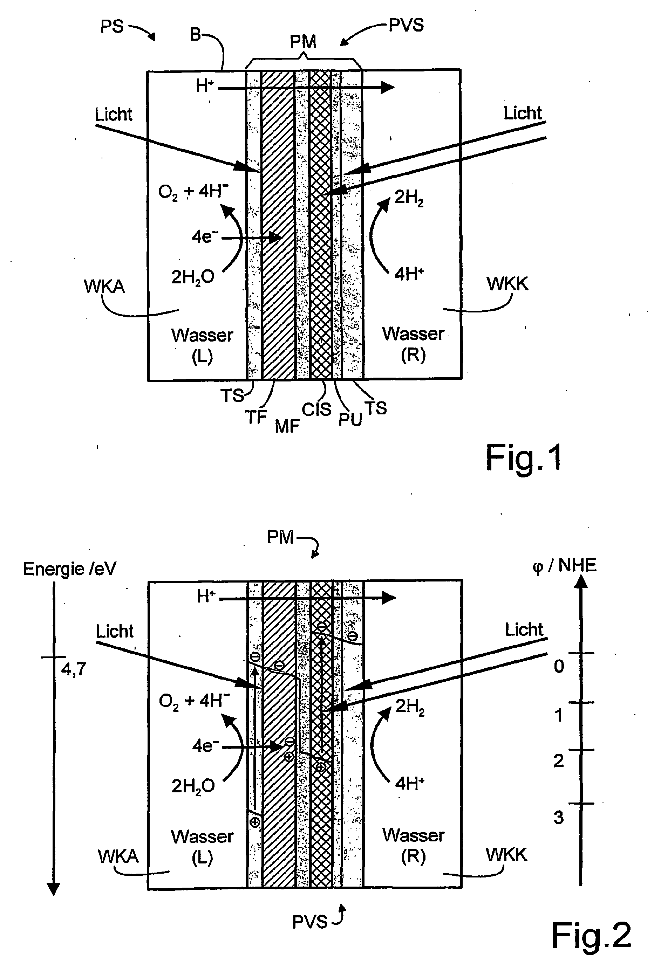

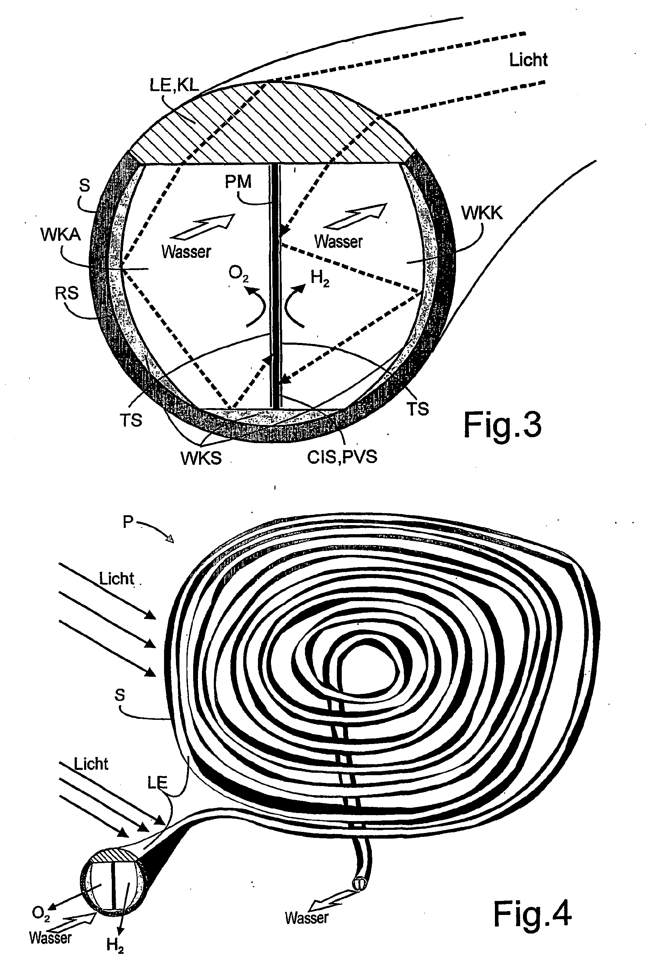

Die **Figur 1** zeigt im Längsschnitt das Prinzipschema einer Photovoltaikmembran **PM** eines Photovoltaiksystems **PS** nach der Erfindung in einem wassergefüllten Behälter **B.** Die Photovoltaikmembran **PM** ist selbsttragend und weist keine lateralen stromsammelnden Elemente auf. Sie teilt das Wasser im Behälter **B** in zwei getrennte Wasserkammern auf, von denen die linke **(L)** anodische Wasserkammer **WKA** der Erzeugung von Sauerstoff und die rechte **(R)** kathodische Wasserkammer **WKK** der Erzeugung von Wasserstoff dient. Auf einer Trägerfolie **TF** aus Titan Ti mit einer Folienstärke von beispielsweise 0,2 mm ist nach rechts zur kathodischen Wasserkammer **WKK** eine stromsammlungsfreie Photgvoltaikstruktur **PVS** aufgebracht, die im gezeigten Ausführungsbeispiel aus einer Metallfolie **MF** aus Molybdän Mo, dem Schichtaufbau einer CulnS₂-Solarzelle **CIS** und einer transparenten Pufferschicht **PU** aufgebaut ist. Auf beiden Seiten wird die Photovoltaikmembran **PM** von einer lichtdurchlässigen Titandioxidschicht **TS** bedeckt, die dem Korrosionsschutz der Photovoltaikstruktur **PVS** und auch der Katalyse dienen. In der anodischen Wasserkammer **WKA** fungiert die Titandioxidschicht **TS** als Sauerstoffkatalysator und ist zur Verbesserung ihrer spektralen Lichtempfindlichkeit mit Stickstoff N, Schwefel S oder Kohlenstoff C dotiert. In der kathodischen Wasserkammer **WKA** ist die Titandioxidschicht **TS** als Wasserstoffkatalysator eingesetzt und mit Nickelmolybdän-Teilchen Ni-Mo dotiert, um ihre Katalysefähigkeit für die Wasserstofffreisetzung zu verbessern. Für eine weiter verbesserte Lichtempfindlichkeit der photoaktiven Titandioxidschichten **TS** sind diese noch zusätzlich mit lichtreaktiven Farbstoffpartikeln dotiert. Die Photovoltaikmembran **PM** wird von beiden Seiten mit Sonnenlicht bestrahlt, in die Photovoltaikstruktur PVS fällt Licht von einer Seite. Zur Lichtführung siehe auch **Figur 3****.** Die Photovoltaikmembran **PM** weist im oberen Bereich noch eine Protonenschleuse **PRS** zur Überführung der Protonen in die kathodische Wasserkammer **WKK** auf (in der **Figur 1** nur durch einen Pfeil angedeutet).

In der **Figur 2** ist das Energieschema der Photovoltaikmembran **PM** in bezug auf die Elektronenenergie in eV (linke Achse) und das Potenzial bezogen auf eine normierte Wasserstoffelektrode (NHE) (rechte Achse) dargestellt. In der anodischen Wasserkammer **WKA** wird Wasser in Sauerstoff und Wasserstoffionen aufgespalten. Der Sauerstoff wird abgeführt, die freigewordenen Elektronen durchwandern als Elektronenstrom die Photovoltaikmembran **PM,** in der im Bereich der Photovoltaikstruktur **PVS** durch Lichteinfall ein Photopotenzial erzeugt wird, das den Solarstrom zusätzlich antreibt. In der rechten Wasserkammer **WKK** wird Wasserstoff erzeugt (jeweils angedeutet durch die chemischen Reaktionsformeln).

In der **Figur 3** ist im Querschnitt eine licht- und brennstoffsammeinde Schlauchstruktur gezeigt. In einem flexiblen Schlauch **S** ist eine flexible Photovoltaikmembran **PM** als Trennwand angeordnet. Der Schlauch **S** kann nahezu beliebig lang sein und weist über seine gesamte Länge die trennende Photovoltaikmembran **PM** mit den Titandioxidoberflächen auf. Im oberen Bereich verfügt der Schlauch S über einen flexiblen lichtdurchlässigen Einsatz **LE,** im gewählten Ausführungsbeispiel handelt es sich dabei um eine kreissegmentförmige Kunststofflinse **KL,** durch die Licht in das Schlauchinnere einfällt. Die Photovoltaikmembran PM wird oben von dem Einsatz **LE,** unten von dem Schlauch **S** (oder einer Reflexionseinrichtung s.u.) begrenzt, sodass zwei getrennte Wasserkammern **WKA , WKK** entstehen, die sich ebenfalls über die gesamte Schlauchlänge erstrecken. Die Wasserkammern **WKA, WKK** werden in derselben Richtung kontinuierlich von Wasser durchströmt, das die getrennt erzeugten Dissoziationsgase (hier Sauerstoff und Wasserstoff) mit sich führt und weiterleitet. Auf seiner Innenseite ist der Schlauch S mit einer reflektierenden Oberfläche **RS,** hier aus Aluminium, und einer versiegelnden, korrosionsfesten SiO₂-Schicht bedeckt. Daran schließt sich eine Winston-artig ausgebildete Kollektorstruktur **WKS** an, durch deren speziell gewölbte Oberflächen eine vollständige Reflexion des einfallenden Sonnenlichts in die Photovoltaikmembran **PM** sicher gewährleistet ist.

Die **Figur 4** zeigt schematisch den licht- und brennstoffsammeinden Schlauch **S** in der Perspektive in Form einer Paneele **P** in spiralförmig aufgerolltem Zustand, hier mit einer zentralen Wasserzufuhr. Durch die spiralförmige Anordnung mit einem nach der Sonne ausgerichteten flexiblen Lichteinsatz **LE** kann optimal mit einem minimalen Platzbedarf der Anordnung eine maximale Sonneneinstrahlung und damit eine maximale Wasserstoffproduktion erzielt werden.

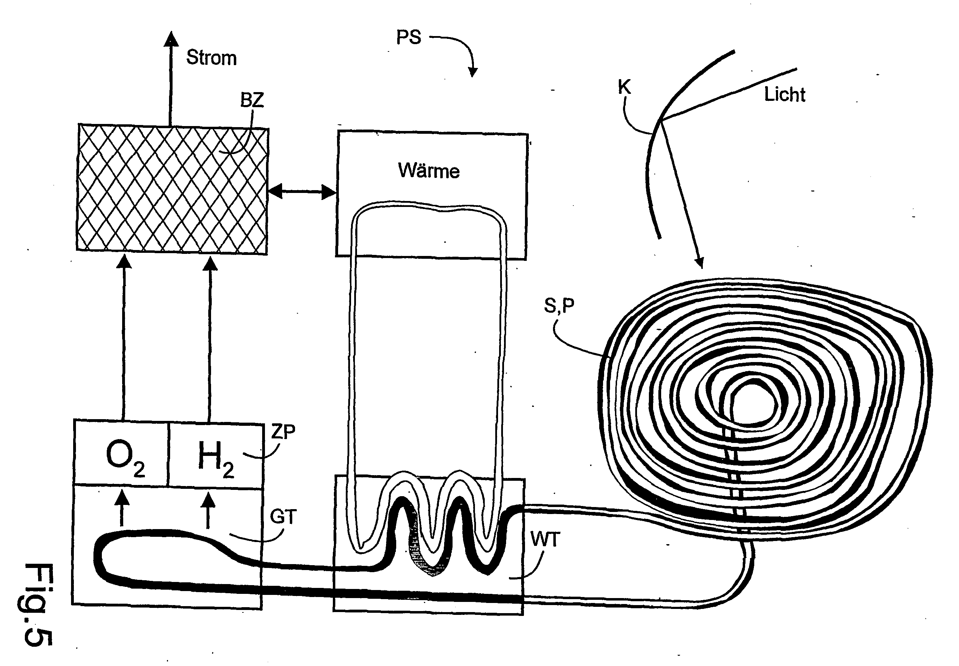

In der **Figur 5** ist die Einbindung des licht- und brennstoffsammelnden Schlauchs S in Paneelform **P** in ein komplettes Photovoltaiksysterh **PS** gezeigt. Über einen Konzentrator **K** wird das Sonnenlicht auf den aufgewickelten Schlauch **S** geleitet. Die im durchfließenden Wasser erzeugte Wärme wird in einem Wärmetauscher **WT** abgegeben. Die im durchfließenden Wasser erzeugten Dissoziationsgase werden im dargestellten Ausführungsbeispiel über einen Gastauscher **GT** einem Zwischenspeicher **ZP** zugeführt. Mit den Brennstoffgasen wird eine Brennstoffzelle **BZ** (oder ein Array davon) betrieben, die umweltfreundlich elektrischen Strom produziert. Die abgeführte Wärme kann zur Unterstützung der Brennstoffzellenfunktion, aber auch vielseitig zur solaren Wärmenutzung in Wohneinrichtungen und Gewerbebetrieben eingesetzt werden.

### Bezugszeichenliste

- **B**: Behälter
- **BZ**: Brennstoffzelle
- **CIS**: CulnS₂-Solarzelle
- **GT**: Gastauscher
- **K**: Konzentrator

- **KL**: Kunststofflinse
- **L**: linke Seite (anodisch)
- **LE**: lichtdurchlässiger Einsatz
- **MF**: Metallfolie
- **P**: Paneele
- **PM**: Photovoltaikmembran
- **PRS**: Protonenschleuse
- **PS**: Photovoltaiksystem
- **PU**: Pufferschicht
- **PVS**: Photovoltaikstruktur
- **R**: rechte Seite (kathodisch)
- **RS**: reflektierende Oberfläche
- **S**: Schlauch
- **TF**: Trägerfolie
- **TS**: Titandioxidschicht
- **WKA**: anodische Wasserkammer
- **WKK**: kathodische Wasserkammer
- **WKS**: Winston-artig ausgebildete Kollektorstruktur
- **WT**: Wärmetauscher
- **ZP**: Zwischenspeicher

## Patentansprüche

1. Photovoltaiksystem (PS) für die direkte Wasserstofferzeugung und - sammlung durch einen Elektrolysestrom in einem Behälter (S) mit einer von Wasser umgebenen und von beiden Seiten mit gesammeltem Sonnenlicht bestrahlten, photoelektrochemisch aktiven Photovoltaikstruktur (PVS) ohne laterale stromsammelnde Elemente, die eine eine integrierte Protonenschleuse (PRS) aufweisende selbsttragende Membran umfasst, die das umgebende Wasser gegenüber dem Behälter (S) in zwei getrennte Wasserkammern (WKK, WKA) zur Wasserstoff- und zur Sauerstofferzeugung unterteilt, wobei auf der der Wasserkammer (WKA) zur Sauerstofferzeugung zugewandten Seite der Photovoltaikstruktur (PVS) eine Titandioxidschicht (TS) vorgesehen ist,
**dadurch gekennzeichnet, dass**
die Membran als vom Elektrolysestrom durchflossene Photovoltaikmembran (PM) ausgebildet und auf beiden Seiten mit einer elektrisch leitenden und lichtdurchlässigen Titandioxidschicht (TS) belegt ist, wobei die Titandioxidschicht (TS) auf der einen Seite (L) der Photovoltaikmembran (PM) durch Dotierung mit Stickstoff, Schwefel oder Kohlenstoff oder Kombinationen davon sauerstoffkatalysierende Eigenschaften hat und die Titanoxidschicht (TS) auf der der Wasserkammer (WKA) zur Sauerstofferzeugung zugewandten Seite des Photovoltaikstruktur (PVS) bildet und die Titandioxidschicht (TS) auf der anderen Seite (R) der Photovoltaikmembran (PM) durch Einlagerung von Nickelmolybdänpartikeln oder ähnlich wirkenden Wasserstoffkatalysatoren oder Kombinationen davon wasserstoffkatalysierende Eigenschaften hat.

2. Photovoltaiksystem nach Anspruch 1,
**dadurch gekennzeichnet, dass**
in die Titandioxidschichten (TS) photoaktive Farbstoffpigmente eingelagert sind.

3. Photovoltaiksystem nach Anspruch 1 oder 2,
**dadurch gekennzeichnet, dass**
die Photovoltaikmembran (PM) flexibel ausgebildet ist.

4. Photovoltaiksystem nach Anspruch 3,
**dadurch gekennzeichnet, dass**
die Photovoltaikmembran (PM) eine zentrale, flexible Trägerfolie (TF), insbesondere aus Titan, aufweist.

5. Photovoltaiksystem nach einem der Ansprüche 1 bis 4,
**dadurch gekennzeichnet, dass**
die integrierte Photovoltaikstruktur (PVS) eine Tandem-Dünnschichtsolarzelle, insbesondere unter Nutzung einer vereinfachten Kupfer-Indium-(Sulfid, Sele-nid)-Tandem-Solarzelle (CIS), oder eine amorphe oder kristalline Silizium-Solarzelle umfasst.

6. Photovoltaiksystem nach Anspruch 5,
**dadurch gekennzeichnet, dass**
in der Tandem-Dünnschichtsolarzelle (CIS) öder in der Silizium-Solarzelle die üblichen Zink-Oxid-Fensterschichten durch die Titandioxidschichten (TS) ersetzt und die stromsammelnden Elemente entfernt sind.

7. Photovoltaiksystem nach einem der Ansprüche 3 bis 6,
**dadurch gekennzeichnet, dass**
die flexible Photovoltaikmembran (PM) als sich axial erstreckende Trennwand in einem flexiblen Schlauch (S) beliebiger Länge als Behälter angeordnet ist und der Schlauch (S) einen sich axial oberhalb der Photovoltaikmembran (PM) erstreckenden flexiblen lichtdurchlässigen Einsatz (LE) als Lichtführung aufweist, wobei die Photovoltaikmembran (PM) unten von der Schlauchwandung und oben von dem lichtdurchlässigen Einsatz (LE) unter Bildung der beiden getrennten Wasserkammern (WKA, WKK) abgeschlossen wird und wobei der Schlauch (S) kontinuierlich in beiden Wasserkammern (WKA, WKK) von Wasser in derselben Richtung durchflossen wird und die im Photovoltaiksystem (PS) entstehenden Dissoziationsgase zu Gastauschern (GT) mitführt.

8. Photovoltaiksystem nach Anspruch 7,
dadurch gekenntzeichnet, dass
der lichtdurchlässige Einsatz (LE) als Kunststofflinse (KL) mit einem kreisabschnittsförmigen Querschnitt ausgebildet ist.

9. Photovoltaiksystem nach Anspruch 7 oder 8,
**dadurch gekennzeichnet, dass**
in der Photovoltaikmembran (PM) in regelmäßigen Abständen Membranelemente als Protonenschleusen (PRS) angeordnet sind.

10. Photovoltaiksystem nach einem der Ansprüche 7 bis 9,
**dadurch gekennzeichnet, dass**
der Schlauch (S) auf seiner Innenseite im Bereich der beiden getrennten Wasserkammern (WKA, WKK) eine reflektierende Oberfläche (RS) als weitere Lichtführung aufweist

11. Photovoltaiksystem nach Anspruch 10,
**dadurch gekennzeichnet, dass**
die reflektierende Oberfläche (RS) als Aluminiumschicht, die mit einer wasserkorrosionsbeständigen Siliziumdioxidschicht bedeckt ist, ausgebildet ist.

12. Photovoltaiksystem nach einem der Ansprüche 7 bis 11,
**dadurch gekennzeichnet, dass**
der Schlauch (S) auf seiner Innenseite im Bereich der beiden getrennten Wasserkammern (WKA, WKK) eine winstonartige Kollektorstruktur (WKA) als weitere Lichtführung aufweist.

13. Photovoltaiksystem nach einem der Ansprüche 7 bis 12,
**dadurch gekennzeichnet, dass**
der Schlauch (S) in einer beliebig geformten Paneele (P), insbesondere in Form einer flächigen Schlauchspirale, ausgelegt ist.

14. Photovoltaiksystem nach einem der Ansprüche 7 bis 13,
**dadurch gekennzeichnet, dass**
das den Schlauch (S) durchfließende Wasser über einen integrierten Wärmetauscher (WT) geleitet wird.

15. Photovoltaiksystem nach einem der Ansprüche 1 bis 14,
**dadurch gekennzeichnet, dass**
das bestrahlende Sonnenlicht über einen Konzentrator (K) als weitere Lichtführung auf die Photovoltaikmembran (PM) gelenkt wird.

## Claims

1. A photovoltaic system (PS) for direct hydrogen production and collection by an electrolysis current in a container (S) comprising a photoelectrochemically active photovoltaic structure (PVS) which has no lateral current-collecting elements, is surrounded by water and irradiated on either side by concentrated sunlight and comprises a self-supporting membrane comprising an integrated proton lock (PRS) which divides the surrounding water from the container (S) into two separate water chambers (WKK, WKA) for hydrogen and oxygen generation, a titanium dioxide layer (TS) being provided on the side of the photovoltaic structure (PVS) facing the water chamber (WKA) for oxygen generation,
**characterised in that**
the membrane is formed as a photovoltaic membrane (PM) through which the electrolysis current flows and is coated on either side with an electrically conductive and transparent titanium dioxide layer (TS), the titanium dioxide layer (TS) having oxygen-catalysing properties on one side (L) of the photovoltaic membrane (PM) as a result of doping with nitrogen, sulphur or carbon or combinations thereof and forming the titanium dioxide layer (TS) on the side of the photovoltaic structure (PVS) facing the water chamber (WKA) for oxygen generation, and the titanium dioxide layer (TS) having hydrogen-catalysing properties on the other side (R) of the photovoltaic membrane (PM) as a result of deposition of nickel-molybdenum particles or similarly acting hydrogen catalysts or combinations thereof.

2. The photovoltaic system according to claim 1,
**characterised in that**
photoactive pigments are incorporated into the titanium dioxide layers (TS).

3. The photovoltaic system according to either claim 1 or claim 2,
**characterised in that**
the photovoltaic membrane (PM) is flexible.

4. The photovoltaic system according to claim 3,
**characterised in that**
the photovoltaic membrane (PM) comprises a central, flexible carrier film (TF), in particular made of titanium.

5. The photovoltaic system according to any one of claims 1 to 4,
**characterised in that**
the integrated photovoltaic structure (PVS) comprises a tandem thin-film solar cell, in particular with use of a simplified copper-indium (sulphide, selenide) tandem solar cell (CIS) or an amorphous or crystalline silicon solar cell.

6. The photovoltaic system according to claim 5,
**characterised in that**,
in the tandem thin-film solar cell (CIS) or in the silicon solar cell, the conventional zinc-oxide window layers are replaced by the titanium dioxide layers (TS) and the current-collecting elements are removed.

7. The photovoltaic system according to any one of claims 3 to 6,
**characterised in that**
the flexible photovoltaic membrane (PM) is arranged as an axially extending partition wall in a flexible hose (S) of any length as a container and the hose (S) comprises a flexible transparent insert (LE) extending axially above the photovoltaic membrane (PM) as a light guide, the photovoltaic membrane (PM) being closed from below by the hose wall and from above by the transparent insert (LE) with formation of the two separate water chambers (WKA, WKK), and in both water chambers (WKA, WKK) water flowing through the hose (S) in the same direction continuously and the dissociation gas produced in the photovoltaic system (PS) being entrained to gas exchangers (GT).

8. The photovoltaic system according to claim 7,
**characterised in that**
the transparent insert (LE) is formed as a plastics material lens (KL) having a cross-section shaped as a segment of a circle.

9. The photovoltaic system according to either claim 7 or claim 8,
**characterised in that**
membrane elements are arranged at regular distances in the photovoltaic membrane (PM) as proton locks (PRS).

10. The photovoltaic system according to any one of claims 7 to 9,
**characterised in that**
the hose (S) comprises a reflective surface (RS) as a further light guide on the inner face in the region of the two separate water chambers (WKA, WKK).

11. The photovoltaic system according to claim 10,
**characterised in that**
the reflective surface (RS) is formed as an aluminium layer which is covered with a water-corrosion-resistant silicon dioxide layer.

12. The photovoltaic system according to any one of claims 7 to 11,
**characterised in that**
the hose (S) comprises on the inner face thereof in the region of the two separate water chambers (WKA, WKK) a Winston-like collector structure (WKA) as a further light guide.

13. The photovoltaic system according to any one of claims 7 to 12,
**characterised in that**
the hose (S) is formed in a panel (P) of any form, in particular in the form of a flat hose spiral.

14. The photovoltaic system according to any one of claims 7 to 13,
**characterised in that**
the water flowing through the hose (S) is guided via an integrated heat exchanger (WT).

15. The photovoltaic system according to any one of claims 1 to 14,
**characterised in that**
the irradiating sunlight is directed onto the photovoltaic membrane (PM) via a concentrator (K) as a further light guide.

## Revendications

1. System photovoltaïque (PS) destiné à directement produire et recueillir de l'hydrogène, au moyen d'un courant d'électrolyse circulant dans un récipient (S) renfermant une structure photovoltaïque (PVS) dépourvue d'éléments latéraux collecteurs de courant et possédant une activité photo-électrochimique, ladite structure étant entourée d'eau, ayant deux faces qui reçoivent de la lumière solaire concentrée et comprenant une membrane autoporteuse qui comporte une pompe à protons (PRS) intégrée, ladite membrane divisant le bain d'eau au sein du récipient (S) en deux chambres d'eau séparées (WKK, WKA) destinées à la production d'hydrogène et d'oxygène, une couche en dioxyde de titane (TS) étant prévue sur la face de la structure photovoltaïque (PVS) qui est tournée vers la chambre d'eau (WKA) destinée à la production d'oxygène,
**caractérisé en ce que**
ladite membrane est réalisée sous forme d'une membrane photovoltaïque (PM) dans laquelle circule ledit courant électrolyse et dont les deux faces sont recouvertes d'une couche en dioxyde de titane (TS) électriquement conductrice et transparente, la couche en dioxyde de titane (TS) sur l'une (L) des faces de la membrane photovoltaïque (PM) étant dopée avec de l' azote, du soufre ou du carbone ou leurs combinaisons afin de lui conférer des propriétés catalytiques vis-à-vis de l'oxygène et formant la couche en dioxyde de titane (TS) située sur la face de la structure photovoltaïque (PVS) tournée vers la chambre d'eau (WKA) destinée à la production d'oxygène, et la couche en dioxyde de titane (TS) sur l'autre face (R) de la membrane photovoltaïque (PM) présentant des incorporations de particules de nickel-molybdène ou de catalyseurs d'hydrogène ayant un effet similaire ou de leurs combinaisons afin de lui conférer des propriétés catalytiques vis-à-vis de l'hydrogène.

2. System photovoltaïque selon la revendication 1,
**caractérisé en ce que**
les couches en dioxyde de titane (TS) présentent des incorporations de colorants pigmentaires photo-actifs.

3. System photovoltaïque selon les revendications 1 ou 2,
**caractérisé en ce que**
la membrane photovoltaïque (PM) est réalisée sous une forme flexible.

4. System photovoltaïque selon la revendication 3,
**caractérisé en ce que**
la membrane photovoltaïque (PM) présente une feuille de support (TF) centrale flexible,
notamment en titane.

5. System photovoltaïque selon l'une des revendications 1 à 4.
**caractérisé en ce que**
la structure photovoltaïque (PVS) intégrée comprend une cellule solaire à couches minces en tandem, en utilisant notamment une cellule solaire simplifiée de type cuivre-indium (sulfure, séléniure) en tandem (CIS), ou une cellule solaire en silicium amorphe ou cristallin.

6. System photovoltaïque selon la revendication 5,
**caractérisé en ce que**,
au sein de ladite cellule solaire à couches minces en tandem (CIS) ou au sein de ladite cellule solaire en silicium, les couches transparentes habituelles en oxyde de zinc sont remplacées par les couches en dioxyde de titane (TS) et que les éléments collecteurs de courant ont été supprimés.

7. System photovoltaïque selon l'une des revendications 3 à 6,
**caractérisé en ce que**
la membrane photovoltaïque (PM) flexible est disposée sous forme d'une paroi de séparation qui s'étend axialement dans un tuyau (S) flexible d'une quelconque longueur, de façon à former un récipient, et le tuyau (S) présentant un empiècement transparent (LE) s'étendant axialement au-dessus de la membrane photovoltaïque (PM) et servant à guider la lumière, la membrane photovoltaïque (PM) butant en bas sur la paroi du tuyau et en haut sur l'empiècement transparent (LE), de façon à former les deux chambres d'eau séparées (WKA, WKK), et que de l'eau circule en permanence et dans le même sens dans les deux chambres d'eau (WKA, WKK) du tuyau (S) et achemine les gaz de dissociation produits dans le system photovoltaïque vers des échangeurs de gaz (GT).

8. System photovoltaïque selon la revendication 7,
**caractérisé en ce que**
l'empiècement transparent (LE) est réalisé sous forme d'une lentille en matière plastique (KL) dont le profil transversal a la forme d'une section circulaire.

9. System photovoltaïque selon les revendications 7 ou 8,
**caractérisé en ce que**
des éléments de membrane servant de pompes à protons (PRS) sont disposés, à des distances régulières, dans la membrane photovoltaïque (PM).

10. System photovoltaïque selon l'une des revendications 7 à 9,
**caractérisé en ce que**
le tuyau (S) présente, sur sa face intérieure au niveau des deux chambres d'eau séparées (WKA, WKK), une surface réfléchissante (RS) servant également à guider la lumière.

11. System photovoltaïque selon la revendication 10,
**caractérisé en ce que**
la surface réfléchissante (RS) est réalisée sous forme d'une couche en aluminium recouverte d'une couche en dioxyde de silicium résistant à toute corrosion que l'eau peut provoquer.

12. System photovoltaïque selon l'une des revendications 7 à 11,
**caractérisé en ce que**
le tuyau (S) présente, sur sa face intérieure au niveau des deux chambres d'eau séparées (WKA, WKK), une structure collectrice de type Winston (WKA) servant également à guider la lumière.

13. System photovoltaïque selon l'une des revendications 7 à 12,
**caractérisé en ce que**
le tuyau (S) est disposé dans une formation plate (P) d'une quelconque forme, notamment sous la forme d'un tuyau étalé spirale.

14. System photovoltaïque selon l'une des revendications 7 à 13,
**caractérisé en ce que**
l'on fait passer l'eau circulant dans le tuyau (S) par un échangeur de chaleur (WT) intégré.

15. System photovoltaïque selon l'une des revendications 1 à 14,
**caractérisé en ce que**
la lumière solaire incidente est dirigée vers la membrane photovoltaïque (PM) par un concentrateur (K) servant également à guider la lumière.
